# EUROPEAN PATENT SPECIFICATION

(11) **EP 3 163 672 B1**
(45) Date of publication and mention of the grant of the patent: **20.02.2019**
(21) Application number: 15814735.5
(22) Date of filing: 09.04.2015
(51) Int. Cl.: H01M 10/48, H01M 2/10, H02J 7/00

(54) **METHOD FOR DETERMINING ABNORMALITY IN BATTERY PACK, AND DEVICE FOR DETERMINING ABNORMALITY IN BATTERY PACK**
VERFAHREN ZUR BESTIMMUNG VON ANOMALIEN IN EINEM BATTERIEPACK UND VORRICHTUNG ZUR BESTIMMUNG VON ANOMALIEN IN EINEM BATTERIEPACK
PROCÉDÉ DE DÉTERMINATION D'ANOMALIE DANS UN BLOC-BATTERIE, ET DISPOSITIF DE DÉTERMINATION D'ANOMALIE DANS UN BLOC-BATTERIE

(30) Priority: 30.06.2014 JP 2014134250; 27.11.2014 JP 2014240224
(43) Date of publication of application: 03.05.2017
(73) Proprietor: Toyo Tire & Rubber Co., Ltd., Hyogo 664-0847 (JP)
(72) Inventor: FUKUDA, Takeshi, ITAMI-SHI HYOGO 664-0847 (JP); MINAKATA, Nobuyuki, ITAMI-SHI HYOGO 664-0847 (JP)
(74) Representative: Sajda, Wolf E.
(86) International application number: PCT/JP2015/061130
(87) International publication number: WO 2016/002295

(56) References cited:
- EP-A1- 2 645 527
- WO-A2-2012/170873
- JP-A- 2008 234 840
- JP-A- 2010 527 127
- JP-A- 2013 101 868
- JP-A- 2014 098 688
- KR-A- 20110 093 358
- US-A1- 2014 002 269

## Description

### TECHNICAL FIELD

The present invention relates to a method for determining an abnormality and a device for determining an abnormality in an assembled battery that is formed by connecting, in series, a plurality of parallel bodies each formed by connecting a plurality of secondary battery cells in parallel.

### BACKGROUND ART

In recent years, a sealed secondary battery represented by a lithium ion secondary battery is used as a power source not only for a mobile apparatus such as a portable phone or a notebook personal computer but also for an electrically driven vehicle such as an electric automobile or a hybrid car. A cell constituting the secondary battery, that is, a secondary battery cell (which may be referred to as a cell), includes an electrode group formed by winding or stacking a positive electrode and a negative electrode with a separator interposed therebetween, and an outer casing that accommodates the electrode group.

Generally, a laminate film or a metal can is used as the outer casing, and the electrode group is accommodated together with an electrolytic solution in a sealed space located in the inside thereof.

For use that requires a high voltage such as in a power source for the above-mentioned electrically driven vehicles, a battery module formed by accommodating an assembled battery composed of a plurality of secondary battery cells in a case is used. Generally, such an assembled battery is formed by connecting, in series, a plurality of parallel bodies of secondary battery cells.

For example, an assembled battery known as two in parallel by two in series is used in which two parallel bodies, each of which is formed by connecting two secondary battery cells in parallel, are connected in series. The battery module mounted on a vehicle is used in a form of a battery pack. In the battery pack, a plurality of battery modules connected in series are accommodated in a case together with various apparatus such as a controller.

In the meantime, when an abnormality occurs in one of the secondary battery cells constituting the assembled battery, troubles may occur due to the abnormality. For example, when an abnormality of overcharging occurs and the electrolytic solution is decomposed, the secondary battery cell expands following a rise in the internal pressure caused by the decomposition gas.

When the charging and discharging are not shut off in that state, ignition or rupture occurs. In order to avoid such troubles appropriately, mere determination of the presence or absence of the abnormality may be insufficient in some cases, so that there is a need for a technique capable of specifying, among the secondary battery cells constituting the assembled battery, in which one of the secondary battery cells the abnormality has occurred. Also, a technique capable of inferring the type of the abnormality is more desirable.

Patent Documents 1 and 2 disclose a device for determining an abnormality in an assembled battery formed by connecting a plurality of secondary battery cells in series. Also, Patent Document 3 discloses a device for determining a deterioration of a battery. However, these devices make determinations based on various voltages, so that there are cases in which these devices are not suitable for an assembled battery including parallel bodies of secondary battery cells.

In other words, it seems that, among the secondary battery cells that are in a parallel relationship, the voltages thereof are equal to one another, so that it is difficult to make a distinction even if an abnormality has occurred in one of the secondary battery cells, thereby lowering the detection precision.

Patent Document 4 discloses a method of measuring a change in stress of a secondary battery cell using a strain gauge and detecting the time of completion of charging based on the measured result. However, this method merely detects a change in stress from a normal secondary battery cell, and cannot determine that an abnormality has occurred in any of the secondary battery cells.

Moreover, it seems that the method cannot specify, among the secondary battery cells constituting an assembled battery, in which one of the secondary battery cells the abnormality has occurred.

Patent Document 5 relates to a battery pack comprising a battery module and a battery management system for controlling charging and discharging of the battery module via an external terminal, wherein the battery management system is arranged to limit a state of charge of the battery module to be within a charging and discharging range between a charging limit and a discharging limit, the battery pack further comprising a sensor unit for detecting swelling in the battery module, wherein the battery management system is arranged to limit the state of charge of the battery module in response to the detection of swelling in the battery module.

Patent Document 6 relates to detecting swelling in batteries supplying power to electrical equipment, at least one contact sensor such as quantum tunneling composite ("QTC") based pressure-capacitive sensor coated on one surface with a layer of conductive material such as indium tin oxide ("ITO") or a capacitive sensor coated with the same conductive material is used for attachment to each battery. A capacitance measuring module including a microcontroller is connected to the contact sensor and measures the capacitance of the ITO-coated conductor. If the capacitance under measurement represents an increase in capacitance exceeding a predetermined threshold, indicative of battery swelling, a call for battery replacement and interruption of battery power to the electrical equipment are initiated.

Patent Document 7 relates to an apparatus for sensing and controlling the swelling of a secondary cell is provided to effectively sense a swelling phenomenon generated from a secondary battery cell and to differentially interface the announcement according to the swelling phenomenon. The apparatus for sensing and controlling the swelling of a secondary cell comprises: sensing wires surrounds the outside of a battery cell; connection holes fitted to the end of the sensing wire; a signal generator occurring a sensing signal according to the physical movement when the end of the sensing wire physically moves from the connection hole; and a controller controlling the battery cell to limit the use of the battery cell if the sensing signal is sensed.

### PRIOR ART DOCUMENTS

### PATENT DOCUMENTS

Patent Document 1: JP 2001-025 173 A
Patent Document 2: JP 2007-018 871 A
Patent Document 3: JP 2002-345 164 A
Patent Document 4: JP 05-326 027 A
Patent Document 5: EP 2 645 527 A1
Patent Document 6: US 2014/002269 A1
Patent Document 7: KR 2011 0093358 A

### SUMMARY OF THE INVENTION

### PROBLEMS TO BE SOLVED BY THE INVENTION

The present invention has been made in view of the above-described circumstances, and an object thereof is to provide a method for determining an abnormality in an assembled battery and a device for determining an abnormality in an assembled battery in which, with respect to an assembled battery including parallel bodies of secondary battery cells, it is determined that an abnormality has occurred in a specific secondary battery cell among the secondary battery cells constituting the assembled battery.

### MEANS FOR SOLVING THE PROBLEMS

The present invention provides a method for determining an abnormality in an assembled battery that is formed by connecting, in series, a plurality of parallel bodies each formed by connecting a plurality of secondary battery cells in parallel, the method comprising:
detecting swelling in each of the secondary battery cells by using a detection sensor mounted on each of the secondary battery cells; and
determining, based on swelling detected in two or more of the secondary battery cells, that an abnormality has occurred in a specific secondary battery cell among the two or more of the secondary battery cells, wherein the detection sensor has a polymer matrix layer, and the polymer matrix layer contains a filler that is dispersed therein and that changes an external field in accordance with a deformation of the polymer matrix layer, and
the polymer matrix layer is attached to any of the secondary battery cells, and swelling of the secondary battery cells is detected by a change in the external field that accords to the deformation of the polymer matrix layer.

This abnormality determination method determines, based on swelling of each of the secondary battery cells, that an abnormality has occurred in a specific secondary battery cell among the secondary battery cells. The swelling of the secondary battery cells is detected by a detection sensor mounted on each of the secondary battery cells constituting the assembled battery.

The present inventors have paid attention to the fact that, when an abnormality of overcharging described above or another abnormality occurs, various phenomena are seen with respect to the swelling of secondary battery cells, and have conceived of a technique of determining an abnormality of a specific secondary battery cell with respect to an assembled battery including parallel bodies of secondary battery cells by using, as an index, an aspect of swelling that is detected in two or more of the secondary battery cells.

Further, the present invention provides a device for determining an abnormality in an assembled battery that is formed by connecting, in series, a plurality of parallel bodies each formed by connecting a plurality of secondary battery cells in parallel, the device comprising:
a detection sensor that is mounted on each of the secondary battery cells and that detects swelling in the secondary battery cells; and
abnormality determination means for determining, based on swelling detected in two or more of the secondary battery cells, that an abnormality has occurred in a specific secondary battery cell among the two or more of the secondary battery cells wherein the detection sensor has a polymer matrix layer which is attached to any of the secondary battery cells and a detection unit, and
   the polymer matrix layer contains a filler that is dispersed therein and that is adapted to change an external field in accordance with deformation of the polymer matrix layer, and the detection unit is adapted to detect a change in the external field.

Thereby, there is provided a device for implementing the abnormality determination method mentioned above.

In the method for determining an abnormality or the device for determining an abnormality in an assembled battery according to the present invention, the following first to fourth aspects can be mentioned as examples of the specific determination processes on the occurrence of the abnormality in secondary battery cells.

In a first aspect, when the swelling of a first secondary battery cell is larger than the swelling of a secondary battery cell that is in a series relationship with the first secondary battery cell and when the swelling of a second secondary battery cell that is in a parallel relationship with the first secondary battery cell is smaller than the swelling of a secondary battery cell that is in a series relationship with the second secondary battery cell during charging, it is determined that an abnormality has occurred in the second secondary battery cell. It is inferred that a resistance abnormality has occurred in this second secondary battery cell.

When the first and second secondary battery cells are in a parallel relationship and when a resistance abnormality occurs, for example, in the second secondary battery cell, the first secondary battery cell swells largely during the charging. This is due to the following reason. Because the secondary battery cells connected in a parallel relationship have the same voltage, a large electric current flows through the first secondary battery cell in accordance with rise in the resistance of the second secondary battery cell.

Also, as compared with the swelling of a normal secondary battery cell that is in a series relationship with the first and second secondary battery cells, the swelling of the first secondary battery cell is large, and the swelling of the second secondary battery cell is small. Therefore, according to the first aspect, a secondary battery cell in which a resistance abnormality has occurred can be specified.

In a second aspect, when a speed of swelling of at least one of the secondary battery cells is above a predetermined value and when speeds of swelling of at least two of the other secondary battery cells are each below the predetermined value and are substantially equal to one another, it is determined that an abnormality has occurred in the at least one secondary battery cell of which the speed of swelling is above the predetermined value. It is inferred that an abnormality of overcharging has occurred in this secondary battery cell of which the speed of swelling is above the predetermined value.

When a secondary battery cell during the charging is normal, the swelling of that secondary battery cell is mainly caused by a change in volume of an active substance. In contrast, in a secondary battery cell in which the abnormality of overcharging has occurred, the swelling is promoted by the decomposition gas of the electrolytic solution, so that the speed of swelling (amount of change of swelling per unit period of time) becomes higher as compared with a normal secondary battery cell.

Therefore, when there is a secondary battery cell of which the speed of swelling is above a predetermined value and when the speeds of swelling of other secondary battery cells are each below the predetermined value and are substantially equal to one another, it is highly probable that an abnormality of overcharging has occurred in the secondary battery cell of which the speed of swelling is above the predetermined value. In this manner, according to the second aspect, a secondary battery cell in which an abnormality of overcharging has occurred can be specified.

In a third aspect, when a difference of swelling among at least two of the secondary battery cells is above a predetermined value in a stationary state in which charging or discharging is not carried out, it is determined that an abnormality has occurred in the secondary battery cell having the larger swelling among the at least two secondary battery cells. It is inferred that an abnormality of gas generation has occurred in the secondary battery cell having the larger swelling.

When all the secondary battery cells are normal in a stationary state in which charging or discharging is not carried out, it is expected that the charging depths and the discharging depths of these cells are equivalent to one another and the amounts of change in volume of an active substance that contributes to charging and discharging are equal.

Therefore, when a difference of swelling among two or more of the secondary battery cells is so large as to be above a predetermined value, it is highly probable that an abnormality of gas generation has occurred in the secondary battery cell having the larger swelling. In this manner, according to the third aspect, a secondary battery cell in which an abnormality of gas generation has occurred can be specified.

In a fourth aspect, when a difference in an amount of change of swelling between two points having different charging depths in one charging and discharging cycle among at least two of the secondary battery cells is above a predetermined value in a stationary state in which charging or discharging is not carried out, it is determined that an abnormality has occurred in the secondary battery cell having the smaller amount of change of swelling among the at least two secondary battery cells. It is inferred that a deactivation abnormality of an active substance has occurred in this secondary battery cell having the smaller amount of change of swelling.

By comparing an amount of change of swelling between two points having different charging depths in one charging and discharging cycle in a stationary state in which charging or discharging is not carried out, an amount of change in the volume of the active substance accompanying the charging and discharging can be compared under conditions in which difference in the amount of gas generation in the secondary battery cells can be ignored.

Therefore, when a difference in the amount of change of swelling is large, the amount of change in the volume of the active substance differs largely among the compared secondary battery cells. This means that there is a secondary battery cell in which the active substance contributing to charging and discharging has decreased in amount, and it is highly probable that a deactivation abnormality of the active substance has occurred in this secondary battery cell. In this manner, according to the fourth aspect, a secondary battery cell in which a deactivation abnormality of an active substance has occurred can be specified.

In order to avoid troubles that are caused by an abnormality of a secondary battery cell appropriately, it is preferable to shut off the charging and discharging of the assembled battery in accordance with a determination that the abnormality has occurred in the secondary battery cell.

It is preferable that the detection sensor has a polymer matrix layer, and the polymer matrix layer contains a filler that is dispersed therein and that changes an external field in accordance with a deformation of the polymer matrix layer, and the polymer matrix layer is attached to any of the secondary battery cells, and swelling of the secondary battery cells is detected by a change in the external field that accords to the deformation of the polymer matrix layer. This allows that the swelling of secondary battery cells can be detected with a high degree of sensitivity, and occurrence of an abnormality can be determined at a high precision.

In the above method, it is preferable that the polymer matrix layer contains a magnetic filler as the filler, and the detection unit detects a change in a magnetic field as the external field. This allows that a change in the magnetic field accompanying the deformation of the polymer matrix layer can be detected without a wiring. Also, because a Hall element having a wide sensitivity region can be used as the detection unit, detection with a high degree of sensitivity can be made in a wider range.

### BRIEF DESCRIPTION OF THE DRAWINGS

FIG. 1 is a block diagram showing a system having a device for determining an abnormality according to the present invention.
FIG. 2 is a perspective view illustrating one example of a secondary battery cell on which a detection sensor is mounted.
FIG. 3 is a graph for illustrating an amount of change of swelling.
FIG. 4 is a perspective view illustrating other example of a secondary battery cell on which a detection sensor is mounted.
FIG. 5 is a cross sectional view taken along the line A-A in FIG. 4.
FIG. 6 is a perspective view illustrating other example of a secondary battery cell on which a detection sensor is mounted.
FIG. 7 is a cross sectional view taken along the line B-B in FIG. 6.

### MODE FOR CARRYING OUT THE INVENTION

An embodiment of the present invention will be explained.

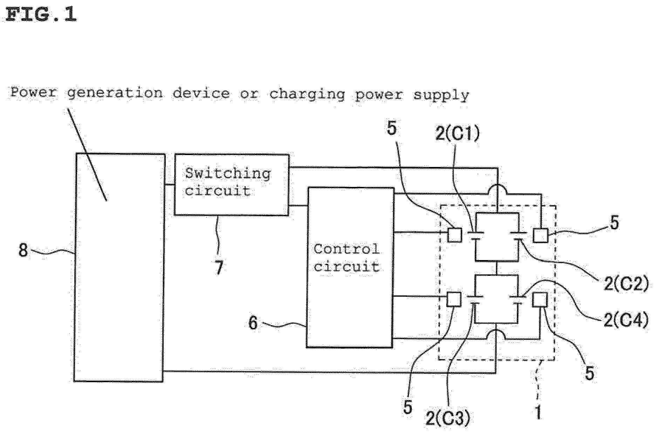

FIG. 1 shows a system that is mounted on an electrically driven vehicle such as an electric automobile or a hybrid car. This system has an abnormality determination device which is one embodiment of the present invention, and includes a battery module 1 which is a chargeable and dischargeable secondary battery. Although only one battery module 1 is illustrated in the drawing, the system in actual cases is equipped with a battery pack including a plurality of battery modules 1.

In the battery pack, a plurality of battery modules 1 are connected in series, and the battery modules 1 are accommodated in a case together with various apparatus such as a controller. The case of the battery pack is formed in a shape suitable for mounting on a vehicle, for example, a shape that conforms to the under-floor shape of the vehicle.

In the battery module 1, an assembled battery composed of a plurality of secondary battery cells 2 (which may be hereinafter simply referred to as "cells 2") is accommodated in a case. In the present embodiment, an assembled battery known as two in parallel by two in series is used in which two parallel bodies, each of which is made of two cells 2, are connected in series.

The construction of the assembled battery is not particularly limited as long as a plurality of parallel bodies, each of which is formed by connecting a plurality of secondary battery cells in parallel, are connected in series. In other words, the number of secondary battery cells constituting the parallel body may be three or more, and the number of parallel bodies connected in series may be three or more. In any case, the assembled battery that is put to use is composed of four or more secondary battery cells.

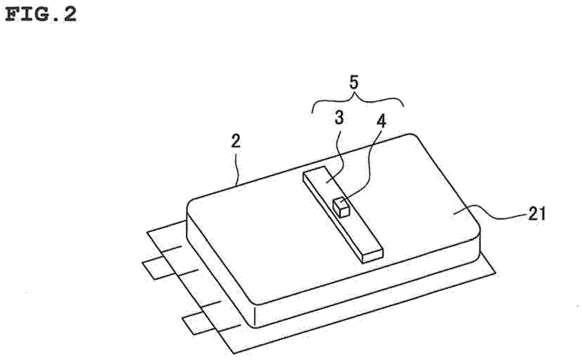

As shown in FIG. 2, the cell 2 is a sealed secondary battery in which an electrode group (not illustrated in the drawings) is accommodated in a sealed space located within an outer casing 21. The electrode group has a structure in which a positive electrode and a negative electrode are wound or stacked with a separator interposed therebetween, and an electrolytic solution is held in the separator.

The outer casing 21 is a laminate film such as an aluminum laminate foil; however, a cylindrical or prismatic metal can may be used in place of this. In the present embodiment, an example is shown in which the cell 2 is a laminate-type lithium ion secondary battery having a capacity of 1.44 Ah (size: longitudinal side 90 mm × lateral side 30 mm × thickness 4 mm).

The abnormality determination device includes a detection sensor 5 and abnormality determination means. The detection sensor 5 is mounted on each of the cells 2 and detects swelling of the cells 2. The abnormality determination means determines, based on swelling detected in two or more of the cells 2, that an abnormality has occurred in a specific secondary battery cell among these.

Signals obtained by detection with the detection sensor 5 are forwarded to a control circuit 6, and this allows that information on the swelling of each of the cells 2 is supplied to the control circuit 6. The control circuit 6 performs the above determination on the basis of the information. The abnormality determination means is realized by execution of such determination processes carried out by the control circuit 6.

The following first to fourth aspects may be mentioned as examples of specific determination processes. The abnormality determination means is configured to execute at least one of the first to fourth aspects, preferably all of the first to fourth aspects. For ease of description, the four cells 2 may be referred to as cells C1 to C4 for distinction among these.

In the first aspect, when the swelling of a cell C1 (one example of a first secondary battery cell) is larger than the swelling of a secondary battery cell that is in a series relationship with the cell C1 and when the swelling of a cell C2 (one example of a second secondary battery cell) that is in a parallel relationship with the cell C1 is smaller than the swelling of a secondary battery cell that is in a series relationship with the cell C2 during charging, it is determined that an abnormality has occurred in the cell C2. In this case, it is inferred that a resistance abnormality has occurred in the cell C2. Any one of the cells C2 to C4 may correspond to the first secondary battery cell.

In a parallel body including the cell C2 in which a resistance abnormality has occurred, the other cell C1 belonging to the parallel body swells largely during the charging at a constant electric current in the battery module 1. This is due to the following reason. Because the cells C1 and C2 that are in a parallel relationship have the same voltage, a large electric current flows through the cell C1 to increase the charging depth in accordance with rise in the resistance of the cell C2.

Also, as compared with the swelling of the normal cells C3 are C4 that are respectively in a series relationship with the cell C1 or C2, the swelling of the cell C1 is large, and the swelling of the cell C2 having the abnormality is small. Therefore, in the first aspect, a secondary battery cell in which a resistance abnormality has occurred can be specified.

The secondary battery cell that is in a series relationship with the cell C1 and the secondary battery cell that is in a series relationship with the cell C2 that have been described above may be either one of the cells C3 and C4; however, it is preferable to use the same secondary battery cell as an object. However, in a state in which the cells C3 and C4 are normal, the swelling of these are substantially the same, so that the secondary battery cells whose swelling is compared with that of the cells C1 and C2 need not be the same. Also, in comparing the swelling, a predetermined value that is set in advance as an acceptable error range can be considered.

As described above, when the swelling of the cell C1 is larger than the swelling of the cell C3 (or C4) and when the swelling of the cell C2 is smaller than the swelling of the cell C3 (or C4), it is determined that an abnormality has occurred in the cell C2. In this case, it is possible to add conditions that the difference in swelling between the cell C1 and the cell C2 exceeds a predetermined value. In place of this or in addition to this, it is possible to add conditions that the difference in swelling between the cell C1 and the cell C3 (or C4) and the difference in swelling between the cell C2 and the cell C3 (or C4) each exceed a predetermined value.

Such determination processes are preferably carried out on the basis of the swelling of all the cells C1 to C4 constituting the assembled battery so that, when the cell C2 is normal and an abnormality has occurred in any other one of the secondary battery cells, it is determined that an abnormality has occurred in a specific secondary battery cell (one of the cells C1, C3, and C4) among these.

As described above, according to the first aspect, it is possible to determine that an abnormality has occurred in a specific secondary battery cell (cell C2 in the above-described example) among the cells C1 to C4 constituting the assembled battery, and a resistance abnormality is inferred as a type of the abnormality.

In the second aspect, when a speed of swelling of at least one of the secondary battery cells is above a predetermined value and when speeds of swelling of at least two of the other secondary battery cells are each below the predetermined value and are substantially equal to one another, it is determined that an abnormality has occurred in the at least one secondary battery cell of which the speed of swelling is above the predetermined value. In this case, it is inferred that an abnormality of overcharging has occurred in this secondary battery cell of which the speed of swelling is above the predetermined value. The speed of swelling represents an amount of change of the swelling per unit period of time.

For example, when the speed of swelling of the cell C1 is above a predetermined value and when the speeds of swelling of at least two of the other secondary battery cells are each below the predetermined value and are substantially equal to one another, it is determined that an abnormality has occurred in the cell C1. The at least two of the other secondary battery cells may be any combination of the cells C2 to C4; however, it is preferable to include all the secondary battery cells other than the cell C1. The above predetermined value is a value that is experimentally determined in advance as a speed of swelling in a secondary battery cell in which an abnormality of overcharging has occurred.

When an abnormality of overcharging has occurred in the cell C1, the swelling is promoted in the cell C1 by the decomposition gas of the electrolytic solution, so that the speed of swelling becomes higher as compared with the normal cells C2 to C4. Although swelling occurs in the cells C2 to C4 by change in volume of the active substance caused by charging, the speed thereof is lower as compared with the swelling accompanying the abnormality of overcharging.

Therefore, when there is a cell C1 in which the speed of swelling is above a predetermined value and when the speeds of swelling of other cells C2 to C4 are each below the predetermined value and are substantially equal to one another, it is highly probable that an abnormality of overcharging has occurred in the cell C1. Therefore, in the second aspect, a secondary battery cell in which an abnormality of overcharging has occurred can be specified.

Such determination processes are preferably carried out on the basis of the swelling of all the cells C1 to C4 constituting the assembled battery so that, when the cell C1 is normal and an abnormality has occurred in any other one of the secondary battery cells, it is determined that an abnormality has occurred in a specific secondary battery cell (one of the cells C2 to C4) among these.

As described above, according to the second aspect, it is possible to determine that an abnormality has occurred in a specific secondary battery cell (cell C1 in the above-described example) among the cells C1 to C4 constituting the assembled battery, and a abnormality of overcharging is inferred as a type of the abnormality.

In the third aspect, when a difference of swelling among at least two of the secondary battery cells is above a predetermined value in a stationary state in which charging or discharging is not carried out, it is determined that an abnormality has occurred in the secondary battery cell having the larger swelling among the at least two secondary battery cells. In this case, it is inferred that an abnormality of gas generation has occurred in the secondary battery cell having the larger swelling.

For example, when a difference of swelling between the cell C1 and the cell C2 is above a predetermined value in a stationary state and when the secondary battery cell having the larger swelling between these is the cell C1, it is determined that an abnormality has occurred in the cell C1. A combination of the secondary battery cells that are to be compared is not particularly limited, so that the comparison can be made between secondary battery cells that are in a parallel relationship, or the comparison can be made between secondary battery cells that are in a series relationship.

The above predetermined value is a value that is experimentally determined in advance as a difference of swelling between a cell in which an abnormality of gas generation has occurred and a cell that does not have such an abnormality.

When all the cells C1 to C4 are normal in a stationary state, it is expected that the charging depths and the discharging depths of these are equivalent to one another and the amounts of change in volume of an active substance that contributes to charging and discharging are equal. Therefore, when a difference of swelling between the cell C1 and the cell C2 is so large as to be above a predetermined value even though the assembled battery is in a stationary state and when the swelling of the cell C1 is larger, it is highly probable that an abnormality of gas generation has occurred in the cell C1. Therefore, in the third aspect, a secondary battery cell in which an abnormality of gas generation has occurred can be specified.

Such determination processes are preferably carried out on the basis of the swelling of all the cells C1 to C4 constituting the assembled battery so that, when the cell C1 is normal and an abnormality has occurred in any other one of the secondary battery cells, it is determined that an abnormality has occurred in a specific secondary battery cell (one of the cells C2 to C4) among these.

As described above, according to the third aspect, it is possible to determine that an abnormality has occurred in a specific secondary battery cell (cell C1 in the above-described example) among the cells C1 to C4 constituting the assembled battery, and a abnormality of gas generation is inferred as a type of the abnormality.

In the fourth aspect, when a difference in an amount of change of swelling between two points having different charging depths in one charging and discharging cycle among at least two of the secondary battery cells is above a predetermined value in a stationary state in which charging or discharging is not carried out, it is determined that an abnormality has occurred in the secondary battery cell having the smaller amount of change of swelling among the at least two secondary battery cells. In this case, it is inferred that a deactivation abnormality of an active substance has occurred in this secondary battery cell having the smaller amount of change of swelling.

By comparing an amount of change of swelling between two points having different charging depths in one charging and discharging cycle in a stationary state in which charging or discharging is not carried out, an amount of change in the volume of the active substance accompanying the charging and discharging can be compared under conditions in which difference in the amount of gas generation for each of the secondary battery cells can be ignored.

Therefore, when a difference in the amount of change of swelling is large, the amount of change in the volume of the active substance differs largely among the compared secondary battery cells. This means that there is a secondary battery cell in which the active substance contributing to charging and discharging has decreased in amount, and it is highly probable that a deactivation abnormality of the active substance has occurred in this secondary battery cell. Therefore, according to the fourth aspect, a secondary battery cell in which a deactivation abnormality of an active substance has occurred can be specified.

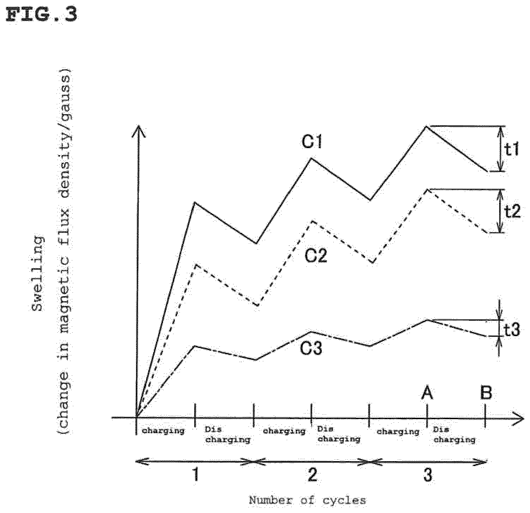

Here, a case in which the swelling of the cells C1 to C3 is in a relationship of FIG. 3 is illustrated. The horizontal axis of the graph represents the number of charging and discharging cycles, and in the graph is shown up to the third cycle of charging and discharging. The vertical axis of the graph represents the swelling of the secondary battery cells, and the swelling is detected as a change in the magnetic flux density (change in the magnetic field) by a detection sensor 5, as described later, that uses magnetism.

For ease of description, the swelling of the cell C4 is not shown; however, in actual cases, it is preferable to make a determination using all the secondary battery cells constituting the assembled battery including the swelling of the cell C4 as an object.

In the example of FIG. 3, an interval from the point A at which the fully charged state of the third cycle is attained to the point B at which the completely discharged state is attained is adopted as an interval between two points having different charging depths in one charging and discharging cycle, and the amounts t1 to t3 of change in swelling of the cells C1 to C3 is calculated.

These two points having different charging depths are selected in an arbitrary manner from the time points in a stationary state in one charging and discharging cycle. When the difference among the amounts t1 to t3 of change of swelling is above a predetermined value, for example, when a difference between t1 and t3 is above a predetermined value, it is inferred that the amount of change in the volume of the active substance differs largely between the cells C1 and C3.

Further, in the cell C3 having the smaller amount of change of swelling, the deactivation abnormality of the active substance is determined, assuming that the active substance contributing to charging and discharging has decreased in amount. The above predetermined value is a value that is experimentally determined in advance as a difference in the amount of change of swelling between a cell in which a deactivation abnormality of an active substance has occurred and a cell that does not have such an abnormality.

When there is a difference in the amount of gas generation among secondary battery cells, there will be a difference in the value of swelling (value on the vertical axis); however, by comparing the amounts t1 to t3 of change of swelling in the above-described manner, conditions in which difference in the amount of gas generation for each of the secondary battery cells can be ignored are attained.

For example, even though there is a difference in the value of swelling (value on the vertical axis) between the cell C1 and the cell C2, the amount of change in the volume of the active substance can be compared under conditions that are not affected by the difference in the amount of gas generation thereof, by using the amounts t1 and t2 of change of swelling thereof. In this example, the amounts t1 and t2 of change of swelling are approximately the same, so that the deactivation abnormality of the active substance is not determined in the cell C2.

As described above, according to the fourth aspect, it is possible to determine that an abnormality has occurred in a specific secondary battery cell (cell C3 in the above-described example) among the cells C1 to C4 constituting the assembled battery, and a deactivation abnormality of the active substance is inferred as a type of the abnormality.

In order to avoid troubles that are caused by an abnormality of a cell 2 appropriately, the abnormality determination device of the present embodiment includes shut-off means for shutting off charging and discharging of the assembled battery in accordance with a determination that an abnormality has occurred in the cell 2. Specifically, when the control circuit 6 determines that an abnormality has occurred in the cell 2 (in one of the cells C1 to C4), the control circuit 6 shuts off the electric current coming from the power generation device (or the charging device) 8 by transmitting a signal to the switching circuit 7 in accordance therewith, thereby producing a state in which the charging and discharging to the assembled battery is shut off. The shut-off means is realized by execution of such processes carried out by the control circuit 6.

In the present embodiment, a detection sensor 5 as shown in FIG. 2 is mounted on the cell 2. The detection sensor 5 includes a polymer matrix layer 3 attached to the cell 2 and a detection unit 4. The polymer matrix layer 3 contains a filler that is dispersed therein and that changes an external field in accordance with deformation of the polymer matrix layer 3.

The detection unit 4 detects change in the external field. When the cell 2 swells to deform the polymer matrix layer 3, change in the external field accompanying the deformation of the polymer matrix layer 3 is detected by the detection unit 4. In this manner, the swelling of the cell 2 is detected by the detection sensor 5.

The polymer matrix layer 3 is formed of an elastomer material or the like that is capable of flexible deformation in accordance with the swelling of the cell 2. The polymer matrix layer 3 is molded, for example, in a sheet form having a longitudinal side of 5 mm × lateral side of 30 mm × thickness of 1.0 mm, and an adhesive agent or an adhesive tape is used for the attaching thereof as necessary. The detection unit 4 is disposed at a site where the change in the external field can be detected, and is preferably attached to a comparatively firm site that is hardly affected by the swelling of the cell 2.

In the present embodiment, the detection unit 4 is attached to an inner surface of a case (not illustrated in the drawings) of the battery module 1; however, the detection unit 4 may be attached to another site such as an outer surface of the case. The case of the battery module 1 is formed, for example, of a metal or a plastic, and there may be cases in which a laminate film is used as the case of the battery module 1.

In the example of FIG. 2, the polymer matrix layer 3 is attached to the outer surface of the outer casing 21. However, the polymer matrix layer 3 may be disposed at another site as long as the swelling of the cell 2 can be detected, so that the polymer matrix layer 3 may be disposed in the inside of the cell 2 as well. Also, the swelling of the cell to be detected may not only be one resulting from rise in the internal pressure caused by gas swelling when an abnormality of overcharging has occurred but also be one resulting from swelling of an electrode caused by deactivation of an electrode active substance such as graphite.

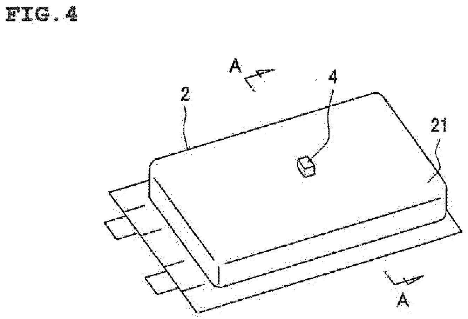

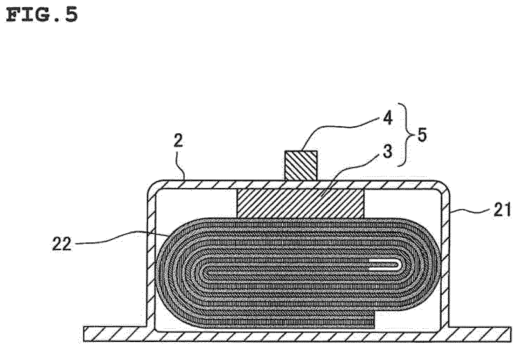

In the example of FIGS. 4 and 5, the polymer matrix layer 3 is attached to the electrode group 22. This electrode group 22 has a structure in which a positive electrode and a negative electrode are wound with a separator interposed therebetween. The polymer matrix layer 3 is interposed between the outer casing 21 and the electrode group 22, and may be disposed to be distant from the inner surface of the outer casing 21.

When the electrode group 22 expands to deform the polymer matrix layer 3, change in the external field accompanying the deformation is detected by the detection unit 4. Therefore, swelling of the cell 2 caused by the swelling of the electrode is detected by the detection sensor 5. The detection unit 4 is attached to the outer surface of the outer casing 21; however, the detection unit 4 maybe attached to the case of the battery module as shown in FIG. 2.

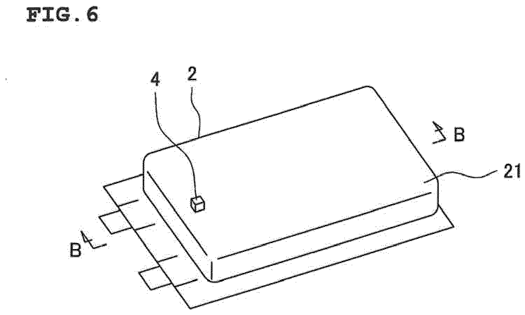

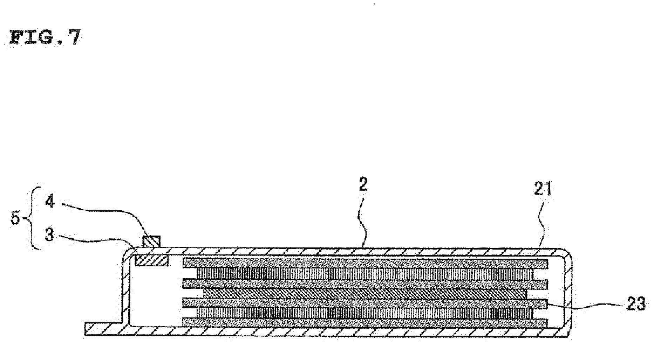

In the example of FIGS. 6 and 7, the polymer matrix layer 3 is attached to the inner surface of the outer casing 21 and is disposed so as not to be in contact with an electrode group 23. The electrode group 23 has a structure in which a positive electrode and a negative electrode are stacked with a separator interposed therebetween.

When the pressure rises by generation of a decomposition gas to deform the polymer matrix layer 3, change in the external field accompanying the deformation is detected by the detection unit 4. The detection unit 4 is attached to the outer surface of the outer casing 21; however, the detection unit 4 may be attached to the case of the battery module as shown in FIG. 2.

In the present embodiment, the polymer matrix layer 3 contains a magnetic filler as the above-described filler, and the detection unit 4 detects change in a magnetic field as the above-described external field. In this case, the polymer matrix layer 3 is preferably a magnetic elastomer layer in which the magnetic filler is dispersed in a matrix that contains an elastomer component.

The magnetic filler may be, for example, a rare-earth-based, iron-based, cobalt-based, nickel-based, or oxide-based filler; however, a rare-earth-based filler is preferable because a higher magnetic force can be obtained. The shape of the magnetic filler is not particularly limited, so that the shape may be any one of spherical, flattened, needle-like, prismatic, and amorphous shapes.

The average particle size of the magnetic filler is preferably from 0.02 to 500 µm, more preferably from 0.1 to 400 µm,and still more preferably from 0.5 to 300 µm. When the average particle size is smaller than 0.02 µm, the magnetic characteristics of the magnetic filler tend to deteriorate. On the other hand, when the average particle size exceeds 500 µm, the mechanical properties of the magnetic elastomer layer tend to deteriorate, and the magnetic elastomer layer tends to be brittle.

The magnetic filler may be introduced into the elastomer after magnetization; however, it is preferable to magnetize the magnetic filler after introduction into the elastomer. By magnetization after introduction into the elastomer, the polarity of the magnet can be easily controlled, and the magnetic field can be easily detected.

A thermoplastic elastomer, a thermosetting elastomer, or a mixture of these can be used as the elastomer component. Examples of the thermoplastic elastomer include a styrene-based thermoplastic elastomer, a polyolefin-based thermoplastic elastomer, a polyurethane-based thermoplastic elastomer, a polyester-based thermoplastic elastomer, a polyamide-based thermoplastic elastomer, a polybutadiene-based thermoplastic elastomer, a polyisoprene-based thermoplastic elastomer, and a fluororubber-based thermoplastic elastomer.

Also, examples of the thermosetting elastomer include diene-based synthetic rubbers such as polyisoprene rubber, polybutadiene rubber, styrene-butadiene rubber, polychloroprene rubber, nitrile rubber, and ethylene-propylene rubber, non-diene-based synthetic rubbers such as ethylene-propylene rubber, butyl rubber, acrylic rubber, polyurethane rubber, fluororubber, silicone rubber, and epichlorohydrin rubber, and natural rubbers.

Among these, a thermosetting elastomer is preferable, and this is because settling of the magnetic elastomer accompanying the heat generation or overloading of the battery can be suppressed. Further, a polyurethane rubber (which may also be referred to as a polyurethane elastomer) or a silicone rubber (which may also be referred to as a silicone elastomer) is more preferable.

A polyurethane elastomer can be obtained by reacting a polyol with a polyisocyanate. In the case in which the polyurethane elastomer is used as the elastomer component, a magnetic filler is mixed with a compound containing active hydrogen, and further an isocyanate component is added thereto to obtain a mixture liquid. Also, a mixture liquid can also be obtained by mixing a magnetic filler with an isocyanate component, and mixing a compound containing active hydrogen thereto.

The magnetic elastomer can be produced by injecting the mixture liquid into a mold that has been subjected to a releasing treatment, and thereafter heating the mixture liquid up to a curing temperature for curing. Also, in the case in which a silicone elastomer is used as the elastomer component, the magnetic elastomer can be produced by putting a magnetic filler into a precursor of a silicone elastomer, mixing the components, putting the resulting mixture into a mold, and thereafter heating the mixture for curing. A solvent may be added as necessary.

A compound known in the art in the field of polyurethane can be used as the isocyanate component that can be used in the polyurethane elastomer. Examples of the isocyanate component include aromatic diisocyanates such as 2,4-toluene diisocyanate, 2,6-toluene diisocyanate, 2,2'-diphenylmethane diisocyanate, 2,4'-diphenylmethane diisocyanate, 4,4'-diphenylmethane diisocyanate, 1,5-naphthalene diisocyanate, p-phenylene diisocyanate, m-phenylene diisocyanate, p-xylylene diisocyanate, and m-xylylene diisocyanate, aliphatic diisocyanates such as ethylene diisocyanate, 2,2,4-trimethylhexamethylene diisocyanate, and 1,6-hexamethylene diisocyanate, and alicyclic diisocyanates such as 1,4-cyclohexane diisocyanate, 4,4'-dicyclohexylmethane diisocyanate, isophorone diisocyanate, and norbornane diisocyanate.

These may be used either alone or as a mixture of two or more kinds. Also, the isocyanate component may be a modified component such as a urethane-modified, allophanate-modified, biuret-modified, or isocyanurate-modified component. Preferable isocyanate components are 2,4-toluene diisocyanate, 2,6-toluene diisocyanate, and 4,4'-diphenylmethane diisocyanate. 2,4-toluene diisocyanate or 2,6-toluene diisocyanate is more preferable.

A compound typically used in the technical field of polyurethane can be used as the compound containing active hydrogen. Examples of the compound containing active hydrogen include high-molecular-weight polyols such as polyether polyols represented by polytetramethylene glycol, polypropylene glycol, polyethylene glycol, and a copolymer of propylene oxide and ethylene oxide, polyester polyols represented by polybutylene adipate, polyethylene adipate, and 3-methyl-1,5-pentane adipate, polyester polycarbonate polyols typified by reaction products of alkylene carbonate and polyester glycol such as polycaprolactone polyol or polycaprolactone, polyester polycarbonate polyols obtained by reacting ethylene carbonate with a polyhydric alcohol and subsequently reacting the obtained reaction mixture with an organic dicarboxylic acid, and polycarbonate polyols obtained by transesterification reaction of a polyhydroxyl compound and aryl carbonate. These may be used either alone or as a mixture of two or more kinds.

In addition to the above-described high-molecular-weight polyol components, low-molecular-weight polyol components such as ethylene glycol, 1,2-propylene glycol, 1,3-propylene glycol, 1,4-butanediol, 1,6-hexanediol, neopentyl glycol, 1,4-cyclohexanedimethanol, 3-methyl-1,5-pentanediol, diethylene glycol, triethylene glycol, 1,4-bis(2-hydroxyethoxy)benzene, trimethylolpropane, glycerin, 1,2,6-hexanetriol, pentaerythritol, tetramethylolcyclohexane, methylglucoside, sorbitol, mannitol, dulcitol, sucrose, 2,2,6,6-tetrakis(hydroxymethyl)cyclohexanol, and triethanolamine, and low-molecular-weight polyamine components such as ethylenediamine, tolylenediamine, diphenylmethanediamine, and diethylenetriamine may be used as the compound containing active hydrogen. These may be used either alone or as a mixture of two or more kinds. Further, polyamines typified by 4,4'-methylenebis(o-chloroaniline) (MOCA), 2,6-dichloro-p-phenylenediamine, 4,4'-methylenebis(2,3-dichloroaniline), 3,5-bis(methylthio)-2,4-toluenediamine, 3,5-bis(methylthio)-2,6-toluenediamine, 3,5-diethyltoluene-2,4-diamine, 3,5-diethyltoluene-2,6-diamine, trimethyleneglycol-di-p-aminobenzoate, polytetramethyleneoxide-di-p-aminobenzoate, 1,2-bis(2-aminophenylthio)ethane, 4,4'-diamino-3,3'-diethyl-5,5'-dimethyldiphenylmethane, N,N'-di-sec-butyl-4,4'-diaminodiphenylmethane, 4,4'-diamino-3,3'-diethyldiphenylmethane, 4,4'-diamino-3,3'-diethyl-5,5'-dimethyldiphenylmethane, 4,4'-diamino-3,3'-diisopropyl-5,5'-dimethyldiphenylmethane, 4,4'-diamino-3,3',5,5'-tetraethyldiphenylmethane, 4,4'-diamino-3,3',5,5'-tetraisopropyldiphenylmethane, m-xylylenediamine, N,N'-di-sec-butyl-p-phenylenediamine, m-phenylenediamine, and p-xylylenediamine may also be mixed. Preferable compounds containing active hydrogen are polytetramethylene glycol, polypropylene glycol, a copolymer of propylene oxide and ethylene oxide, and a polyester polyol made of 3-methyl-1,5-pentanediol and adipic acid. More preferable compounds containing active hydrogen are polypropylene glycol and a copolymer of propylene oxide and ethylene oxide.

A preferable combination of the isocyanate component and the compound containing active hydrogen is a combination of one kind or two more kinds of 2,4-toluene diisocyanate, 2,6-toluene diisocyanate, and 4,4'-diphenylmethane diisocyanate as the isocyanate component and one kind or two more kinds of polytetramethylene glycol, polypropylene glycol, a copolymer of propylene oxide and ethylene oxide, and 3-methyl-1,5-pentane adipate as the compound containing active hydrogen. A more preferable combination is a combination of 2,4-toluene diisocyanate and/or 2,6-toluene diisocyanate as the isocyanate component and polypropylene glycol and/or a copolymer of propylene oxide and ethylene oxide as the compound containing active hydrogen.

For the purpose of preventing rusts of the magnetic filler or the like, a sealing material for sealing the polymer matrix layer 3 may be provided to such a degree that the flexibility of the polymer matrix layer 3 is not deteriorated. A thermoplastic resin, a thermosetting resin, or a mixture of these may be used as the sealing material. The thermoplastic resin may be, for example, styrene-based thermoplastic elastomer, polyolefin-based thermoplastic elastomer, polyurethane-based thermoplastic elastomer, polyester-based thermoplastic elastomer, polyamide-based thermoplastic elastomer, polybutadiene-based thermoplastic elastomer, polyisoprene-based thermoplastic elastomer, fluorine-based thermoplastic elastomer, ethylene·ethyl acrylate copolymer, ethylene·vinyl acetate copolymer, polyvinyl chloride, polyvinylidene chloride, chlorinated polyethylene, fluororesin, polyamide, polyethylene, polypropylene, polyethylene terephthalate, polybutylene terephthalate, polystyrene, polybutadiene, or the like.

The thermosetting resin may be, for example, diene-based synthetic rubbers such as polyisoprene rubber, polybutadiene rubber, styrene·butadiene rubber, polychloroprene rubber, and acrylonitrile·butadiene rubber, non-diene-based rubbers such as ethylene·propylene rubber, ethylene·propylene·diene rubber, butyl rubber, acrylic rubber, polyurethane rubber, fluorine-containing rubber, silicone rubber, and epichlorohydrin rubber, natural rubbers, and thermosetting resins such as polyurethane resin, silicone resin, epoxy resin, or the like. These films may be stacked or may be a film including a metal foil such as aluminum foil or a metal vapor-deposition film including a metal vapor-deposited on the above-described film.

The polymer matrix layer 3 may be a foamed body containing a dispersed filler and bubbles. A general resin foam can be used as the foamed body. However, in view of the characteristics such as compression set, it is preferable to use a thermosetting resin foam. Examples of the thermosetting resin foam include polyurethane resin foam and silicone resin foam. Among these, polyurethane resin foam is preferable. The isocyanate component and the compound containing active hydrogen that have been listed above can be used for the polyurethane resin foam.

The amount of the magnetic filler in the magnetic elastomer is preferably 1 to 450 parts by weight, more preferably 2 to 400 parts by weight, relative to 100 parts by weight of the elastomer component. When the amount is smaller than 1 part by weight, detection of change in the magnetic field tends to be difficult. When the amount exceeds 450 parts by weight, the magnetic elastomer itself may in some cases become brittle.

The polymer matrix layer 3 may be one in which the filler is unevenly distributed in the thickness direction thereof. For example, the polymer matrix layer 3 may be made of two layers, that is, a region on a one side containing a relatively larger amount of the filler and a region on the other side containing a relatively smaller amount of the filler. In the region that is located on the one side and that contains a larger amount of the filler, a large change in the external field results from small deformation of the polymer matrix layer 3, so that the sensor sensitivity to a low internal pressure can be enhanced.

Also, a region that is located on the other side and that contains a relatively smaller amount of the filler is comparatively flexible and can be easily moved. Therefore, by attaching this region located on the other side, the polymer matrix layer 3 (particularly the region located on the one side) becomes capable of being easily deformed.

The filler uneven distribution ratio in the region on the one side preferably exceeds 50, and is more preferably 60 or more, still more preferably 70 or more. In this case, the filler uneven distribution ratio in the region on the other side is less than 50. The filler uneven distribution ratio in the region on the one side is 100 at the maximum, and the filler uneven distribution ratio in the region on the other side is 0 at the minimum. Therefore, it is possible to adopt a stacked body structure including an elastomer layer that contains a filler and an elastomer layer that does not contain the filler.

For uneven distribution of the filler, it is possible to use a method in which, after the filler is introduced into the elastomer component, the resultant is left to stand still at room temperature or at a predetermined temperature, so as to attain natural settling of the filler by the weight of the filler. By changing the temperature or time for leaving the filler to stand still, the filler uneven distribution ratio can be adjusted.

The filler may be distributed unevenly by using a physical force such as a centrifugal force or a magnetic force. Alternatively, the polymer matrix layer may be composed of a stacked body made of a plurality of layers having different contents of the filler.

The filler uneven distribution ratio is measured by the following method. That is, the cross-section of the polymer matrix layer is observed at a magnification of 100 times by using a scanning electron microscope - energy dispersive X-ray analyzer (SEM-EDS). The existence amount of the metal element inherent in the filler (for example, Fe element in the magnetic filler of the present embodiment) is determined by element analysis for the whole region in the thickness direction of the cross-section and for each of the two regions obtained by equally dividing the cross-section into two in the thickness direction.

With respect to this existence amount, the ratio of the existence amount in the region on the one side relative to the existence amount in the whole region in the thickness direction is calculated, and this is determined as the filler uneven distribution ratio in the region on the one side. The filler uneven distribution ratio in the region on the other side can be determined in the same manner.

The region on the other side containing a relatively smaller amount of the filler may have a structure formed of a foamed body containing bubbles. This allows that the polymer matrix layer 3 can be more easily deformed, so that the sensor sensitivity is enhanced. Also, the region on the one side as well as the region on the other side may be formed of a foamed body. In this case, the whole of the polymer matrix layer 3 is made of a foamed body.

The polymer matrix layer in which at least a part thereof in the thickness direction is made of a foamed body may be composed of a stacked body including a plurality of layers (for example, a non-foamed layer that contains a filler and a foamed layer that does not contain a filler).

As the detection unit 4 for detecting change in the magnetic field, a magnetic resistance element, a Hall element, an inductor, an MI element, a flux gate sensor, or the like can be used, for example. As the magnetic resistance element, a semiconductor compound magnetic resistance element, an anisotropic magnetic resistance element (AMR), a gigantic magnetic resistance element (GMR), and a tunnel magnetic resistance element (TMR) may be mentioned as examples.

Among these, a Hall element is preferable, and this is because the Hall element has high sensitivity in a wide range, and is useful as the detection unit 4. As the Hall element, EQ-430L manufactured by Asahi Kasei Microdevices Corporation can be used, for example.

In the above-described embodiment, an example in which the secondary battery cell is a lithium ion secondary battery has been shown; however, the present invention is not limited to this alone. The secondary battery cell that is put to use is not limited to a nonaqueous electrolyte secondary battery such as a lithium ion battery, but may be an aqueous electrolyte secondary battery such as a nickel hydrogen battery.

In the above-described embodiment, an example in which the detection sensor detects swelling by change in the magnetic field has been shown; however, it is possible to adopt a construction in which change in another external field such as an electric field is used. For example, a construction may be considered in which the polymer matrix layer contains an electro-conductive filler such as metal particles, carbon black, or carbon nanotubes as the filler, and the detection unit detects change in the electric field (change in the resistance and the dielectric constant) as the external field.

A known pressure sensor or the like may be used as the detection sensor as long as the detection sensor can detect swelling of each of the secondary battery cells constituting the assembled battery. However, in detecting the swelling of the secondary battery cells with a high degree of sensitivity, a detection sensor including a polymer matrix layer and a detection unit as described above is useful, and this sensor is excellent in usability also because the detection sensor can be disposed in a narrow gap within the battery module.

The present invention is not limited to the embodiment mentioned above, but can be improved and modified variously within the scope of the present invention.

### DESCRIPTION OF REFERENCE SIGNS

- 1: Battery module
- 2: Secondary battery cell
- 3: Polymer matrix layer
- 4: Detection unit
- 5: Detection sensor
- 6: Control circuit
- 7: Switching circuit
- 8: Power generation device or charging power supply
- 21: Outer casing
- 22: Electrode group
- 23: Electrode group

## Claims

1. A method for determining an abnormality in an assembled battery that is formed by connecting, in series, a plurality of parallel bodies each formed by connecting a plurality of secondary battery cells (2) in parallel, the method comprising:
- detecting swelling in each of the secondary battery cells (2) by using a detection sensor (5) mounted on each of the secondary battery cells (2); and
- determining, based on swelling detected in two or more of the secondary battery cells (2), that an abnormality has occurred in a specific secondary battery cell among the two or more of the secondary battery cells (2),
wherein the detection sensor (5) has a polymer matrix layer (3), and the polymer matrix layer (3) contains a filler that is dispersed therein and that changes an external field in accordance with a deformation of the polymer matrix layer (3), and
the polymer matrix layer (3) is attached to any of the secondary battery cells (2), and swelling of the secondary battery cells (2) is detected by a change in the external field that accords to the deformation of the polymer matrix layer (3).

2. The method for determining an abnormality in an assembled battery according to claim 1,
wherein, when the swelling of a first secondary battery cell is larger than the swelling of a secondary battery cell that is in a series relationship with the first secondary battery cell and when the swelling of a second secondary battery cell that is in a parallel relationship with the first secondary battery cell is smaller than the swelling of a secondary battery cell that is in a series relationship with the second secondary battery cell during charging, it is determined that an abnormality has occurred in the second secondary battery cell.

3. The method for determining an abnormality in an assembled battery according to claim 1,
wherein, when a speed of swelling of at least one of the secondary battery cells (2) is above a predetermined value and when speeds of swelling of at least two of the other secondary battery cells (2) are each below the predetermined value and are substantially equal to one another, it is determined that an abnormality has occurred in the at least one secondary battery cell of which the speed of swelling is above the predetermined value.

4. The method for determining an abnormality in an assembled battery according to claim 1,
wherein, when a difference of swelling among at least two of the secondary battery cells (2) is above a predetermined value in a stationary state in which charging or discharging is not carried out, it is determined that an abnormality has occurred in the secondary battery cell having the larger swelling among the at least two secondary battery cells (2).

5. The method for determining an abnormality in an assembled battery according to claim 1,
wherein, when a difference in an amount of change of swelling between two points having different charging depths in one charging and discharging cycle among at least two of the secondary battery cells (2) is above a predetermined value in a stationary state in which charging or discharging is not carried out, it is determined that an abnormality has occurred in the secondary battery cell having the smaller amount of change of swelling among the at least two secondary battery cells (2).

6. The method for determining an abnormality in an assembled battery according to any one of claims 1 to 5,
wherein charging and discharging of the assembled battery are shut off in accordance with a determination that an abnormality has occurred in any of the secondary battery cells (2).

7. The method for determining an abnormality in an assembled battery according to claim 1,
wherein the polymer matrix layer (3) contains a magnetic filler as the filler, and a detection unit (4) detects change in a magnetic field as the external field.

8. A device for determining an abnormality in an assembled battery that is formed by connecting, in series, a plurality of parallel bodies each formed by connecting a plurality of secondary battery cells (2) in parallel, the device comprising:
- a detection sensor (5) that is mounted on each of the secondary battery cells (2) and that is adapted to detect swelling in the secondary battery cells (2); and
- abnormality determination means (6) for determining, based on swelling detected in two or more of the secondary battery cells (2), that an abnormality has occurred in a specific secondary battery cell among the two or more of the secondary battery cells (2),
wherein the detection sensor (5) has a polymer matrix layer (3) which is attached to any of the secondary battery cells (2), and a detection unit (4), and
the polymer matrix layer (3) contains a filler that is dispersed therein and that is adapted to change an external field in accordance with deformation of the polymer matrix layer (3), and the detection unit (4) is adapted to detect a change in the external field.

9. The device for determining an abnormality in an assembled battery according to claim 8,
wherein, when the swelling of a first secondary battery cell is larger than the swelling of a secondary battery cell that is in a series relationship with the first secondary battery cell and when the swelling of a second secondary battery cell that is in a parallel relationship with the first secondary battery cell is smaller than the swelling of a secondary battery cell that is in a series relationship with the second secondary battery cell during charging, the abnormality determination means (6) is adapted to determine that an abnormality has occurred in the second secondary battery cell.

10. The device for determining an abnormality in an assembled battery according to claim 8,
wherein, when a speed of swelling of at least one of the secondary battery cells (2) is above a predetermined value and when speeds of swelling of at least two of the other secondary battery cells (2) are each below the predetermined value and are substantially equal to one another, the abnormality determination means (6) is adapted to determine that an abnormality has occurred in the at least one secondary battery cell of which the speed of swelling is above the predetermined value.

11. The device for determining an abnormality in an assembled battery according to claim 8,
wherein, when a difference of swelling among at least two of the secondary battery cells (2) is above a predetermined value in a stationary state in which charging or discharging is not carried out, the abnormality determination means (6) is adapted to determine that an abnormality has occurred in the secondary battery cell having the larger swelling among the at least two secondary battery cells (2).

12. The device for determining an abnormality in an assembled battery according to claim 8,
wherein, when a difference in an amount of change of swelling between two points having different charging depths in one charging and discharging cycle among at least two of the secondary battery cells (2) is above a predetermined value in a stationary state in which charging or discharging is not carried out, the abnormality determination means (6) is adapted to determine that an abnormality has occurred in the secondary battery cell having the smaller amount of change of swelling among the at least two secondary battery cells (2).

13. The device for determining an abnormality in an assembled battery according to any one of claims 8 to 12,
comprising shut-off means for shutting off charging and discharging of the assembled battery in accordance with a determination that an abnormality has occurred in any of the secondary battery cells (2).

14. The device for determining an abnormality in an assembled battery according to claim 8,
wherein the polymer matrix layer (3) contains a magnetic filler as the filler, and the detection unit (4) is adapted to detect a change in a magnetic field as the external field.

## Patentansprüche

1. Verfahren zum Bestimmen einer Anomalie in einer zusammengesetzten Batterie, welche durch eine Reihenschaltung einer Vielzahl von parallelen Körpern gebildet wird, welche jeweils durch paralleles Verbinden einer Vielzahl von Sekundärbatteriezellen (2) gebildet werden,
wobei das Verfahren folgende Schritte umfasst:
- Detektieren eines Anschwellens in jeder von den sekundären Batteriezellen (2) unter Verwendung eines Detektionssensors (5), welcher an der jeweiligen von den sekundären Batteriezellen (2) angebracht ist; und
- Bestimmen, und zwar basierend auf einem in zwei oder mehreren von den Sekundärbatteriezellen (2) detektierten Anschwellen, dass eine Anomalie in einer spezifischen Sekundärbatteriezelle bei den zwei oder mehreren der Sekundärbatteriezellen (2) aufgetreten ist,
wobei der Detektionssensor (5) eine Polymermatrixschicht (3) aufweist, und wobei die Polymermatrixschicht (3) einen Füllstoff enthält, der darin dispergiert ist und der ein äußeres Feld in Abhängigkeit von einer Verformung der Polymermatrixschicht (3) verändert, und
wobei die Polymermatrixschicht (3) an irgendeiner von den Sekundärbatteriezellen (2) angebracht ist, und wobei das Anschwellen der Sekundärbatteriezelle (2) mittels einer Änderung bei dem äußeren Feld detektiert wird, welches der Verformung der Polymermatrixschicht (3) entspricht.

2. Verfahren zum Bestimmen einer Anomalie in einer zusammengesetzten Batterie gemäß Anspruch 1,
wobei dann, wenn das Anschwellen einer ersten Sekundärbatteriezelle größer ist als das Anschwellen einer Sekundärbatteriezelle, welche mit der ersten Sekundärbatteriezelle in Reihe geschaltet ist, und wenn das Anschwellen einer zweiten Sekundärbatteriezelle, welche parallel zu der ersten Sekundärbatteriezelle geschaltet ist, kleiner ist als das Anschwellen einer Sekundärbatteriezelle, welche während des Ladens in Reihe mit der zweiten Sekundärbatteriezelle geschaltet ist, es bestimmt wird, dass eine Anomalie in der zweiten Sekundärbatteriezelle aufgetreten ist.

3. Verfahren zum Bestimmen einer Anomalie in einer zusammengesetzten Batterie gemäß Anspruch 1,
wobei dann, wenn die Anschwell-Geschwindigkeit von mindestens einer von den sekundären Batteriezellen (2) über einem vorbestimmten Wert liegt und wenn die Anschwell-Geschwindigkeiten von mindestens zwei von den anderen Sekundärbatteriezellen (2) jeweils unter dem vorbestimmten Wert liegen und im Wesentlichen gleich zueinander sind, es bestimmt wird, dass eine Anomalie in der mindestens einen Sekundärbatteriezelle aufgetreten ist, deren Anschwell-Geschwindigkeit über dem vorbestimmten Wert liegt.

4. Verfahren zum Bestimmen einer Anomalie in einer zusammengesetzten Batterie gemäß Anspruch 1,
wobei dann, wenn die Anschwell-Differenz bei mindestens zwei von den Sekundärbatteriezellen (2) in einem stationären Zustand, in dem ein Laden oder Entladen nicht durchgeführt wird, über einem vorbestimmten Wert liegt, es bestimmt wird, dass eine Anomalie in der Sekundärbatteriezelle mit dem höheren Anschwellen bei den mindestens zwei Sekundärbatteriezellen (2) aufgetreten ist.

5. Verfahren zum Bestimmen einer Anomalie in einer zusammengesetzten Batterie gemäß Anspruch 1,
wobei dann, wenn die Differenz bei einem Änderungswert des Anschwellens zwischen zwei Punkten mit unterschiedlichen Ladetiefen in einem Lade- und Entladezyklus bei mindestens zwei der Sekundärbatteriezellen (2) über einem vorbestimmten Wert in einem stationären Zustand liegt, in dem ein Laden oder Entladen nicht durchgeführt wird, es bestimmt wird, dass eine Anomalie in der Sekundärbatteriezelle mit dem kleineren Änderungswert des Anschwellens bei den mindestens zwei Sekundärbatteriezellen (2) aufgetreten ist.

6. Verfahren zum Bestimmen einer Anomalie in einer zusammengesetzten Batterie gemäß einem der Ansprüche 1 bis 5,
wobei das Laden und Entladen der zusammengesetzten Batterie in Abhängigkeit von einer Bestimmung abgeschaltet wird, dass eine Anomalie in einer der Sekundärbatteriezellen (2) aufgetreten ist.

7. Verfahren zum Bestimmen einer Anomalie in einer zusammengesetzten Batterie gemäß Anspruch 1,
wobei die Polymermatrixschicht (3) einen magnetischen Füllstoff enthält und wobei eine Detektionseinheit (4) eine Änderung bei einem Magnetfeld als äußerem Feld erfasst.

8. Vorrichtung zum Bestimmen einer Anomalie in einer zusammengesetzten Batterie, die mittels einer Reihenschaltung von einer Vielzahl von parallelen Körpern gebildet ist, die jeweils durch das Parallelschalten einer Vielzahl von Sekundärbatteriezellen (2) gebildet sind,
wobei die Vorrichtung Folgendes aufweist:
- einen Detektionssensor (5), der an der jeweiligen der Sekundärbatteriezellen (2) angebracht ist und dazu ausgebildet ist, ein Anschwellen in den Sekundärbatteriezellen (2) zu erfassen; und
- eine Anomalie-Bestimmungseinheit (6), um basierend auf einem in zwei oder mehreren der Sekundärbatteriezellen (2) detektierten Anschwellen zu bestimmen, dass eine Anomalie in einer spezifischen Sekundärbatteriezelle bei den zwei oder mehreren Sekundärbatteriezellen (2) aufgetreten ist, wobei der Detektionssensor (5) eine Polymermatrixschicht (3), welche an irgendeiner von den Sekundärbatteriezellen (2) angebracht ist, und eine Detektionseinheit (4) aufweist, und
wobei die Polymermatrixschicht (3) einen Füllstoff enthält, welcher darin dispergiert ist und dazu ausgebildet ist, ein äußeres Feld in Abhängigkeit von der Verformung der Polymermatrixschicht (3) zu ändern, und wobei die Detektionseinheit (4) dazu ausgebildet ist, eine Änderung bei dem äußeren Feld zu detektieren.

9. Vorrichtung zum Bestimmen einer Anomalie in einer zusammengesetzten Batterie gemäß Anspruch 8,
wobei dann, wenn das Anschwellen einer ersten Sekundärbatteriezelle größer ist als das Anschwellen einer Sekundärbatteriezelle, die mit der ersten Sekundärbatteriezelle in Reihe geschaltet ist, und wenn das Anschwellen einer zweiten Sekundärbatteriezelle, die parallel zu der ersten Sekundärbatteriezelle geschaltet ist, kleiner ist als das Anschwellen einer Sekundärbatteriezelle, die während des Ladens mit der zweiten Sekundärbatteriezelle in Reihe geschaltet ist, die Anomalie-Bestimmungseinheit (6) dazu ausgebildet ist, zu bestimmen, dass eine Anomalie in der zweiten Sekundärbatteriezelle aufgetreten ist.

10. Vorrichtung zum Bestimmen einer Anomalie in einer zusammengesetzten Batterie gemäß Anspruch 8,
wobei dann, wenn die Anschwell-Geschwindigkeit von mindestens einer von den Sekundärbatteriezellen (2) über einem vorbestimmten Wert liegt und wenn die Anschwell-Geschwindigkeiten von mindestens zwei der anderen Sekundärbatteriezellen (2) jeweils unter dem vorbestimmten Wert liegen und im Wesentlichen gleich sind, die Anomalie-Bestimmungseinheit (6) dazu ausgebildet ist, zu bestimmen, dass eine Anomalie in der mindestens einen Sekundärbatteriezelle aufgetreten ist, deren Anschwell-Geschwindigkeit über dem vorbestimmten Wert liegt.

11. Vorrichtung zum Bestimmen einer Anomalie in einer zusammengesetzten Batterie gemäß Anspruch 8,
wobei dann, wenn die Anschwell-Differenz bei mindestens zwei von den Sekundärbatteriezellen (2) über einen vorbestimmten Wert in einem stationären Zustand liegt, in dem ein Laden oder Entladen nicht durchgeführt wird, die Anomalie-Bestimmungseinheit (6) dazu ausgebildet ist, zu bestimmen, dass eine Anomalie in der Sekundärbatteriezelle mit dem höheren Anschwellen bei den mindestens zwei Sekundärbatteriezellen (2) aufgetreten ist.

12. Vorrichtung zum Bestimmen einer Anomalie in einer zusammengesetzten Batterie gemäß Anspruch 8,
wobei dann, wenn die Differenz bei einem Änderungswert des Anschwellens zwischen zwei Punkten mit unterschiedlichen Ladetiefen in einem Lade- und Entladezyklus bei mindestens zwei der Sekundärbatteriezellen (2) über einem vorbestimmten Wert in einem stationären Zustand liegt, in dem ein Laden oder Entladen nicht durchgeführt wird, die Anomalie-Bestimmungseinheit (6) dazu ausgebildet ist, zu bestimmen, dass eine Anomalie in der Sekundärbatteriezelle mit dem kleineren Änderungswert des Anschwellens bei den mindestens zwei Sekundärbatteriezellen (2) aufgetreten ist.

13. Vorrichtung zum Bestimmen einer Anomalie in einer zusammengesetzten Batterie gemäß einem der Ansprüche 8 bis 12,
wobei die Vorrichtung eine Abschalt-Einrichtung aufweist, um das Laden und Entladen der zusammengesetzten Batterie abzuschalten, und zwar in Abhängigkeit von einer Bestimmung, dass eine Anomalie in einer der Sekundärbatteriezellen (2) aufgetreten ist.

14. Vorrichtung zum Bestimmen einer Anomalie in einer zusammengesetzten Batterie gemäß Anspruch 8,
wobei die Polymermatrixschicht (3) einen magnetischen Füllstoff als Füllstoff enthält, und wobei die Detektionseinheit (4) dazu ausgebildet ist, eine Änderung bei einem Magnetfeld als äußerem Feld zu erfassen.

## Revendications

1. Procédé pour déterminer une anomalie dans une batterie assemblée qui est formée en connectant, en série, une pluralité de corps parallèles formés chacun en connectant une pluralité de cellules de batterie secondaires (2) en parallèle, le procédé comprenant les étapes consistant à :
- détecter un gonflement dans chacune des cellules de batterie secondaires (2) en utilisant un capteur de détection (5) monté sur chacune des cellules de batterie secondaires (2) ; et
- déterminer, sur la base du gonflement détecté dans deux ou plusieurs des cellules de batterie secondaires (2), qu'une anomalie s'est produite dans une cellule de batterie secondaire spécifique parmi les deux ou plusieurs des cellules de batterie secondaires (2),
dans lequel le capteur de détection (5) a une couche de matrice polymère (3), et la couche de matrice polymère (3) contient une charge qui est dispersée à l'intérieur et qui change un champ externe en accord avec une déformation de la couche de matrice polymère (3), et
la couche de matrice polymère (3) est attachée à l'une quelconque des cellules de batterie secondaires (2), et le gonflement des cellules de batterie secondaires (2) est détecté par un changement dans le champ extérieur qui est en accord avec la déformation de la couche de matrice polymère (3).

2. Procédé pour déterminer une anomalie dans une batterie assemblée selon la revendication 1,
dans lequel, quand le gonflement d'une première cellule de batterie secondaire est plus fort que le gonflement d'une cellule de batterie secondaire qui est en relation en série avec la première cellule de batterie secondaire et quand le gonflement d'une seconde cellule de batterie secondaire qui est en relation en parallèle avec la première cellule de batterie secondaire est plus faible que le gonflement d'une cellule de batterie secondaire qui est en relation en série avec la seconde cellule de batterie secondaire pendant la charge, il est déterminé qu'une anomalie s'est produite dans la seconde cellule de batterie secondaire.

3. Procédé pour déterminer une anomalie dans une batterie assemblée selon la revendication 1,
dans lequel, quand une vitesse de gonflement de l'une au moins des cellules de batterie secondaires (2) est au-dessus d'une valeur prédéterminée et quand les vitesses gonflement d'au moins deux des autres cellules de batterie secondaires (2) sont chacune au-dessous de la valeur prédéterminée et sont sensiblement égales l'une à l'autre, il est déterminé qu'une anomalie s'est produite dans ladite au moins une cellule de batterie secondaire dans laquelle la vitesse de gonflement est au-dessus de la valeur prédéterminée.

4. Procédé pour déterminer une anomalie dans une batterie assemblée selon la revendication 1,
dans lequel, quand une différence de gonflement parmi au moins deux des cellules de batterie secondaire (2) est au-dessus d'une valeur prédéterminée dans un état stationnaire dans lequel on ne procède ni à une charge ni à une décharge, il est déterminé qu'une anomalie s'est produite dans la cellule de batterie secondaire ayant le gonflement plus élevé parmi lesdites au moins deux cellules de batterie secondaires (2).

5. Procédé pour déterminer une anomalie dans une batterie assemblée selon la revendication 1,
dans lequel, quand une différence quantitative de changement de gonflement entre deux points ayant des profondeurs de charge différentes dans un cycle de charge et de décharge parmi au moins deux des cellules de batterie secondaires (2) est au-dessus d'une valeur prédéterminée dans un état stationnaire dans lequel on ne procède ni à une charge ni à une décharge, il est déterminé qu'une anomalie s'est produite dans la cellule de batterie secondaire ayant le plus petit changement quantitatif de gonflement parmi lesdites au moins deux cellules de batterie secondaires (2).

6. Procédé pour déterminer une anomalie dans une batterie assemblée selon l'une quelconque des revendications 1 à 5,
dans lequel la charge et la décharge de la batterie assemblée sont arrêtées en accord avec une détermination qu'une anomalie s'est produite dans l'une quelconque des cellules de batterie secondaires (2).

7. Procédé pour déterminer une anomalie dans une batterie assemblée selon la revendication 1,
dans lequel la couche de matrice polymère (3) contient une charge magnétique à titre de charge, et une unité de détection (4) détecte un changement dans le champ magnétique à titre de champ externe.

8. Dispositif pour déterminer une anomalie dans une batterie assemblée qui est formée en connectant en série une pluralité de corps parallèles formés chacun en connectant une pluralité de cellules de batterie secondaires (2) en parallèle, le dispositif comprenant :
- un capteur de détection (5) qui est monté sur chacune des cellules de batterie secondaires (2) et qui est adapté pour détecter un gonflement dans les cellules de batterie secondaires (2) ; et
- un moyen de détermination d'anomalie (6) pour déterminer, sur la base du gonflement détecté dans deux ou plusieurs des cellules de batterie secondaires (2), qu'une anomalie s'est produite dans une cellule de batterie secondaire spécifique parmi les deux ou plusieurs des cellules de batterie secondaires (2),
dans lequel le capteur de détection (5) a une couche de matrice polymère (3) qui est attachée à l'une quelconque des cellules de batterie secondaires (2), et une unité de détection (4), et
la couche de matrice polymère (5) contient une charge qui est dispersée à l'intérieur et qui est adaptée à changer un champ externe en accord avec une déformation de la couche de matrice polymère (3), et l'unité de détection (4) est adaptée pour détecter un changement dans le champ externe.

9. Dispositif pour déterminer une anomalie dans une batterie assemblée selon la revendication 8,
dans lequel, quand le gonflement d'une première cellule de batterie secondaire est plus fort que le gonflement d'une cellule de batterie secondaire qui est en relation en série avec la première cellule de batterie secondaire, et quand le gonflement d'une seconde cellule de batterie secondaire qui est en relation en parallèle avec la première cellule de batterie secondaire est plus faible que le gonflement d'une cellule de batterie secondaire qui est en relation en série avec la seconde cellule de batterie secondaire pendant la charge, le moyen de détermination d'anomalie (6) est adapté pour déterminer qu'une anomalie s'est produite dans la seconde cellule de batterie secondaire.

10. Dispositif pour déterminer une anomalie dans une batterie assemblée selon la revendication 8,
dans lequel, quand une vitesse de gonflement d'une au moins des cellules de batterie secondaires (2) est au-dessus d'une valeur prédéterminée et quand les vitesses gonflement d'au moins deux des autres cellules de batterie secondaires (2) sont chacune au-dessous de la valeur prédéterminée et sont sensiblement égales l'une à l'autre, le moyen de détermination d'anomalie (6) est adapté pour déterminer qu'une anomalie s'est produite dans ladite au moins une cellule de batterie secondaire dont la vitesse de gonflement est au-dessus de la valeur prédéterminée.

11. Dispositif pour déterminer une anomalie dans une batterie assemblée selon la revendication 8,
dans lequel, quand une différence de gonflement parmi au moins deux des cellules de batterie secondaires (2) est au-dessus d'une valeur prédéterminée dans un état stationnaire dans lequel on ne procède ni à une charge ni à une décharge, le moyen de détermination d'anomalie (6) est adapté pour déterminer qu'une anomalie s'est produite dans la cellule de batterie secondaire ayant le gonflement plus fort parmi lesdites au moins deux cellules de batterie secondaires (2).

12. Dispositif pour déterminer une anomalie dans une batterie assemblée selon la revendication 8,
dans lequel, quand une différence de changement quantitatif de gonflement entre deux points ayant des profondeurs de charge différentes dans un cycle de charge et de décharge parmi au moins deux des cellules de batterie secondaires (2) est au-dessus d'une valeur prédéterminée dans un état stationnaire dans lequel on ne procède ni à une charge ni à une décharge, le moyen de détermination d'anomalie (6) est adapté pour déterminer qu'une anomalie s'est produite dans la cellule de batterie secondaire ayant le changement quantitatif de gonflement plus faible parmi lesdites au moins deux cellules de batterie secondaires (2).

13. Dispositif et pour déterminer une anomalie dans une batterie assemblée selon l'une quelconque des revendications 8 à 12,
comprenant un moyen d'arrêt pour arrêter la charge et la décharge de la batterie assemblée en accord avec une détermination qu'une anomalie s'est produite dans l'une quelconque des cellules de batterie secondaires (2).

14. Dispositif et pour déterminer une anomalie dans une batterie assemblée selon la revendication 8,
dans lequel la couche de matrice polymère (3) contient une charge magnétique à titre de charge, et l'unité de détection (4) est adaptée pour détecter un changement dans un champ magnétique à titre de champ externe.
